(19) Europäisches Patentamt
European Patent Office
Office européen des brevets

(11) **EP 4 471 447 A1**

(12) **EUROPEAN PATENT APPLICATION**

(43) Date of publication:
**04.12.2024 Bulletin 2024/49**

(21) Application number: **23176675.9**

(22) Date of filing: **01.06.2023**

(51) International Patent Classification (IPC):
**G01R 33/50** $^{(2006.01)}$  **G01R 33/48** $^{(2006.01)}$

(52) Cooperative Patent Classification (CPC):
**G01R 33/4806; G01R 33/50**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Koninklijke Philips N.V.**
**5656 AG Eindhoven (NL)**

(72) Inventor: **LAMERICHS, Rolf**
**Eindhoven (NL)**

(74) Representative: **Philips Intellectual Property & Standards**
**High Tech Campus 52**
**5656 AG Eindhoven (NL)**

(54) **FUNCTIONAL MAGNETIC RESONANCE IMAGING USING R2* MAPS**

(57)    Disclosed herein is a medical system (100, 300) comprising a memory (110) storing machine executable instructions (120). The medical system further comprises a computational system (104). Execution of the machine executable instruction causes the computational system to receive (200) a calibration R2* map (122) for a three-dimensional field of view (309). The three-dimensional field of view is descriptive of at least a portion of a brain of a subject (318). Execution of the machine executable instructions further causes the computational system to perform the following at least once: receive (202) a current R2* map (124) for the three-dimensional field of view; and calculate (204) a three-dimensional fMRI map (126) by calculating a change between the calibration R2* map and the current R2* map.

Fig. 2

EP 4 471 447 A1

**Description**

FIELD OF THE INVENTION

The invention relates to magnetic resonance imaging, in particular to functional magnetic resonance imaging.

BACKGROUND OF THE INVENTION

Magnetic Resonance Imaging (MRI) is one of the major imaging techniques in medicine. MRI can generate detailed images of soft tissues depending on properties of the water protons in the various tissues. For example, the relaxation rate of the proton signals differ between tissues and these differences are the basis for the contrast in the images. Functional MRI (FMRI) depends on differences in the MRI signal. fMRI is used to visualize areas of brain that are involved in certain task, i.e., motor tasks (finger tapping), cognitive tasks, visual tasks. fMRI can also measure functional networks, areas of the brain that have synchronized activity. The activated brain areas require more oxygen resulting in physiological response that increases blood flow and blood volume. Moreover, a surplus of oxygenated hemoglobin is delivered to the activated area. The altered ratio of oxy- versus deoxy hemoglobin caused a change in the local signal intensity. Since deoxy hemoglobin is paramagnetic its reduction results in decrease of local the local susceptibility, resulting in a longer T2* relaxation rate and an increase in the local signal intensity. The BOLD response reflects the various blood flow effects and the susceptibility changes. In general, these signal changes are in the order of 4%.

SUMMARY OF THE INVENTION

The invention provides for a medical system, a computer program, and a method in the independent claims. Embodiments are given in the dependent claims.
In one aspect the invention provides for a medical system that comprises a memory storing machine-executable instructions. The medical system further comprises a computational system. Execution of the machine-executable instructions causes the computational system to receive a calibration R2* map for a three-dimensional field of view. The three-dimensional field of view is descriptive of at least a portion of a brain of a subject. Execution of the machine-executable instructions further causes the computational system to at least once receive a current R2* map for the three-dimensional field of view and then calculate a three-dimensional fMRI map by calculating a change between the calibration R2* map and the current R2* map.
In another aspect the invention provides for a method of operating a medical system. The method comprises receiving a calibration R2* map from a three-dimensional field of view. The three-dimensional field of view of the subject is descriptive of at least a portion of the brain of a subject. The method further comprises performing the following at least once: receiving a current R2* map for the three-dimensional field of view and calculating a three-dimensional fMRI map by calculating the change between the calibration R2* map and the current R2* map.
In another aspect the invention provides for a computer program comprising machine-executable instructions for execution by a computational system. Execution of the machine-executable instructions causes the computational system to receive a calibration R2* map for a three-dimensional field of view. The three-dimensional field of view of the subject is descriptive of at least a portion of a brain of the subject. Execution of the machine-executable instructions further causes the computational system to perform the following at least once: receive a current R2* map for the three-dimensional field of view and calculate a three-dimensional fMRI map by calculating the change between the calibration R2* map and the current R2* map.

BRIEF DESCRIPTION OF THE DRAWINGS

In the following preferred embodiments of the invention will be described, by way of example only, and with reference to the drawings in which:

Fig. 1 illustrates an example of a medical system.
Fig. 2 shows a flow chart which illustrates a method of using the medical system of Fig. 1.
Fig. 3 illustrates a further example of a medical system.
Fig. 4 shows a flow chart which illustrates a method of using the medical system of Fig. 3.
Fig. 5 illustrates an example of three short-term magnetic resonance images.
Fig. 6 illustrates an example of a So and R2* map calculated from the magnetic resonance images of Fig. 5.
Fig. 7 illustrates two examples of functional magnetic resonance images.
Fig. 8 illustrates an example of a neural activity classification.

DESCRIPTION OF EMBODIMENTS

Like numbered elements in these figures are either equivalent elements or perform the same function. Elements which have been discussed previously will not necessarily be discussed in later figures if the function is equivalent.
Examples may be beneficial because the functional MRI (fMRI) map is calculated using changes in the R2* values instead of using changes the signal intensity. Changes in signal intensity (at a chosen echo time, typically 30 to 35 ms) are used for traditional BOLD fMRI techniques. The signal intensity change is the BOLD contrast, which is known to be contaminated with the confounders such as cardiac effect etc. T2* (R2*) is determined by an exponential fit to data from multiple echoes and is independent of the signal intensity.

The fMRI map or functional magnetic resonance imaging map may be calculated for example by subtracting one of the calibration R2* map and the current R2* map from the other.

The current R2* map may be received multiple times and the three-dimensional fMRI map may for example be calculated as a function of time.

In another example, execution of the machine-executable instructions further causes the computational system to receive at least one calibration group of k-space data of the three-dimensional field of view of the subject acquired according to a magnetic resonance imaging protocol. The magnetic resonance imaging protocol is a multi-point T2* measurement pulse sequence. The at least one calibration group of k-space data may be from a number or multiple acquisitions.

Execution of the machine-executable instructions further causes the computational system to calculate the calibration R2* map for the three-dimensional field of view from the at least one calibration group of k-space data by fitting a multi-point T2* relaxation time to the at least one calibration group of k-space data. T2* is the reciprocal of R2*. Each one of the at least one calibration group of k-space data may represent one acquisition. If there are multiple acquisitions, then for each acquisition there may be a multi-point T2* relaxation time fit to each of these acquisitions and then for example averaged to calculate the calibration R2* map.

Execution of the machine-executable instructions further causes the computational system to receive a measurement group of k-space data of the three-dimensional field of view according to the magnetic resonance imaging protocol. Execution of the machine-executable instructions further causes the computational system to calculate the current R2* map for the three-dimensional field of view by fitting the multi-point T2* relaxation time to the at least one measurement group of the k-space data.

The acquisition of the k-space data for both the calibration group and the measurement group may for example be the identical acquisition. The at least one calibration group of k-space data may be acquired many times initially to determine a baseline. After this various functional magnetic resonance imaging experiments or tests can be performed and the measurement group of k-space data can be measured repeatedly to, for example, construct a trend chart or time-dependent functional magnetic resonance imaging map.

In another example the medical system further comprises a magnetic resonance imaging system. The memory stores pulse sequence commands configured to control the magnetic resonance imaging system to acquire the k-space data according to the magnetic resonance imaging protocol. Execution of the machine-executable instructions further causes the computational system to control the magnetic resonance imaging system with the pulse sequence commands to acquire the at least one calibration group of k-space data. Execution of the machine-executable instructions further causes the computational system to control the magnetic resonance imaging system with the pulse sequence commands to acquire the at least one measurement group of k-space data.

Acquisition of the at least one calibration group of k-space data may be repeated multiple times so that an accurate baseline for the calibration R2* map can be determined. Likewise, the measurement group of k-space data can be acquired repeatedly, as was described above, so that trends or changes as a function of time can be observed.

In another example the acquisition of the at least one measurement group of k-space data is acquired repeatedly. The calculation of a three-dimensional fMRI map is performed when the at least one measurement group of k-space data is received. For example, as a particular measurement group of k-space data is acquired it is then processed to calculate the current R2* map, which in turn is used to calculate the three-dimensional fMRI map. This may be beneficial because it may enable the rapid or real time determination of the three-dimensional fMRI map. This may for example make it useful as a biofeedback or other type of training device.

In another example, execution of the machine-executable instructions further causes the computational system to reconstruct a temporary magnetic resonance image for each member of the calibration group of k-space data. Execution of the machine-executable instructions further causes the computational system to align the temporary magnetic resonance image for each member of the calibration group of k-space data. Execution of the machine-executable instructions further causes the computational system to smooth the temporary magnetic resonance image for each member of the calibration group of k-space data. The calibration R2* map is calculated by performing a log-linear fit to the smooth temporary magnetic resonance image for each member of the calibration group of k-space data.

The calibration R2* map is typically calculated by repeating this process many times and then doing an averaging of the resulting calibration R2* maps.

In another example, execution of the machine-executable instructions further causes the computational system to reconstruct a short-term magnetic resonance image for each member of the measurement group of k-space data. Execution of the machine-executable instructions further causes the computational system to align the short-term magnetic resonance image for each member of the measurement group of k-space data. Execution of the machine-executable instructions further causes the computational system to smooth the short-term magnetic resonance image for each member of the measurement group of k-space data. The current R2* map is calculated by performing a log-linear fit to the smooth short-term magnetic resonance image for each member of the measurement group of k-space data.

In another example, execution of the machine-executable instructions further causes the computational system to align the current R2* map with the calibration R2* map before calculating the three-dimensional fMRI map.

In another example, execution of the machine-executable instructions further causes the computational system to assign a neural activity classification by inputting the detrended three-dimensional map into a classification-matching module.

Execution of the machine-executable instructions further causes the computational system to provide the neural activity classification as a neural activity signal. Depending upon the neural activity of the subject, various portions of the subject's brain may be active. These various patterns may have similarities from person-to-person. The classification-matching module is able to identify the different neural activity classifications and then output the neural activity signal. This embodiment may be beneficial because the neural activity signal may for example be useful in monitoring the state of the subject who is being imaged in the magnetic resonance imaging system. It may also enable such things as being able to provide a biofeedback or control further acquisition of the magnetic resonance imaging data.

In another example execution of the machine-executable instructions further causes the computational system to calculate a detrended three-dimensional map by detrending the three-dimensional fMRI map in comparison to the three-dimensional fMRI maps acquired in previous iterations. Detrending, as used herein, encompasses jumps or changes in the data caused by drifts in the magnetic resonance imaging scanner. Removing these may have the benefit of improving the quality of the data.

In another example the classification module is implemented as a neural network configured to output the neural activity classification. This for example may be implemented by using neural networks typically used for identifying images or classifying images. As such a convolutional neural network may be used. This may be trained by providing a number of benchmark or labeled fMRI maps with a particular neural activity classification. An advantage of using a neural network is that they may perform the neural activity classification rapidly.

In another example the classification matching module is implemented as a system that compares the three-dimensional fMRI map to a library. For example, there may be a database or library of labeled fMRI images and this can be compared to by selecting the one that closely matches it.

In another example the classification matching module is implemented using cluster analysis.

In another example, execution of the machine-executable instructions further causes the computational system to provide the neural activity signal in real time. This may mean that the neural activity signal is provided within a minimum time period. For example, the neural activity signal may be provided within 1 minute in some examples. In other examples it may be provided in less than 30 seconds. In yet other examples it may be provided within 1 second.

In another example the medical system further comprises a user interface device configured to provide sensory stimulation to the subject. Execution of the machine-executable instructions further causes the computational system to control the user interface device with the neural network activity signal to provide a biofeedback system. This embodiment may be beneficial because it may provide a stable biofeedback system.

In another example the pulse sequence is a multi-echo planar imaging pulse sequence.

In another example the pulse sequence is a multi-echo spiral imaging pulse sequence.

In another example the pulse sequence commands are configured to acquire the k-space data from three echoes.

In another example the pulse sequence commands are configured to acquire the k-space data echoes from three or more echoes.

In another example the pulse sequence commands are configured to acquire the k-space data at a first echo between 6 and 14 ms.

In another example the pulse sequence commands are configured to acquire the k-space data at a second echo between 15 and 39 ms.

In another example the pulse sequence commands are configured to acquire the k-space data at a third echo between 40 and 65 ms.

In another example the pulse sequence is a parallel imaging pulse sequence.

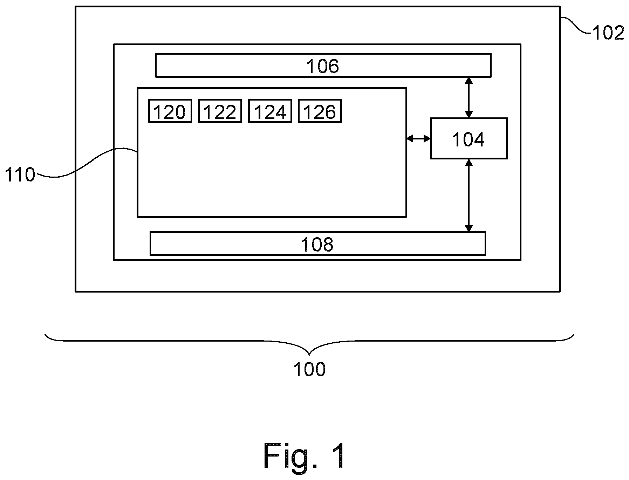

Fig. 1 illustrates an example of a medical system 100. In this example the medical system 100 is shown as comprising a computer 102. The computer 102 may represent one or more computer systems located at one or more locations. The computer 102 is shown as comprising a computational system 104 that may represent one or more computational systems or processors at one or more locations. The computational system 104 is shown as being in communication with an optional hardware interface 106. If the medical system 100 comprises other components the hardware interface 106 may be used to exchange data with and/or control those other components. The computational system 104 is further shown in communication with an optional user interface 108. The user interface 108 may enable an operator or user to control the operation and function of the medical system 100. The computational system 104 is shown as further being in communication with a memory 110. The memory 110 is intended to represent types of volatile or non-volatile memory that may be accessible to the computational system 104.

The memory 110 is further shown as containing machine-executable instructions 120. The machine-executable instructions 120 contain instructions which enable the computational system 104 to perform basic numerical tasks as well as image processing tasks. The machine-executable instructions 120 may also enable the computational system 104 to control other components of the medical system 100 via the hardware interface 106.

The memory 110 is further shown as containing a calibration R2* map 122. The memory 110 is further shown as containing a current R2* map 124. The memory 110 is further shown as containing a three-dimensional fMRI map 126 that has been calculated by calculating the difference between the calibration R2* map 122 and the current R2* map 124. The three-dimensional fMRI map 126 could for example be calculated by subtracting one of the calibration R2* map 122 and the current R2* map 124 from the other.

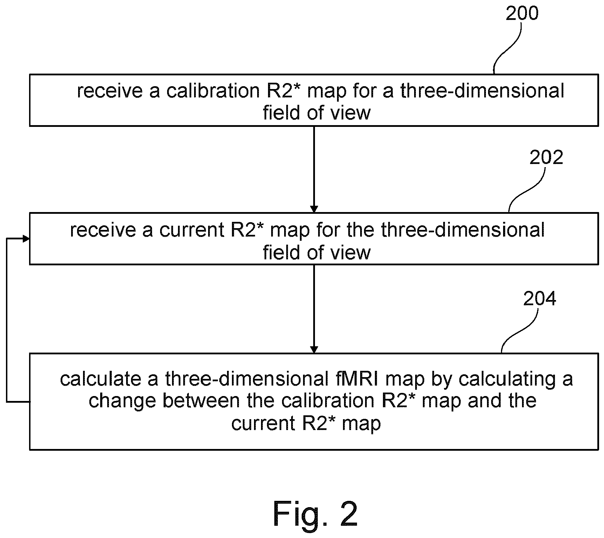

Fig. 2 shows a flowchart which illustrates a method of operating the medical system 100 of Fig. 1. In step 200 the calibration R2* map 122 for a three-dimensional field of view is received. The three-dimensional field of view may be descriptive of at least a portion of a brain of a subject. In step 202 the current R2* map 124 for the same three-dimensional field of view is received. In step 204 the three-dimensional fMRI map 126 is calculated by calculating a change or difference between the calibration R2* map 122 and the current R2* map 124. Steps 202 and 204 may be repeated once or they may be done repeatedly. For example, the subject sitting in the magnetic resonance imaging system could have k-space data acquired continuously or on a regular timetable to repeatedly determine the current R2* map and also the three-dimensional fMRI map.

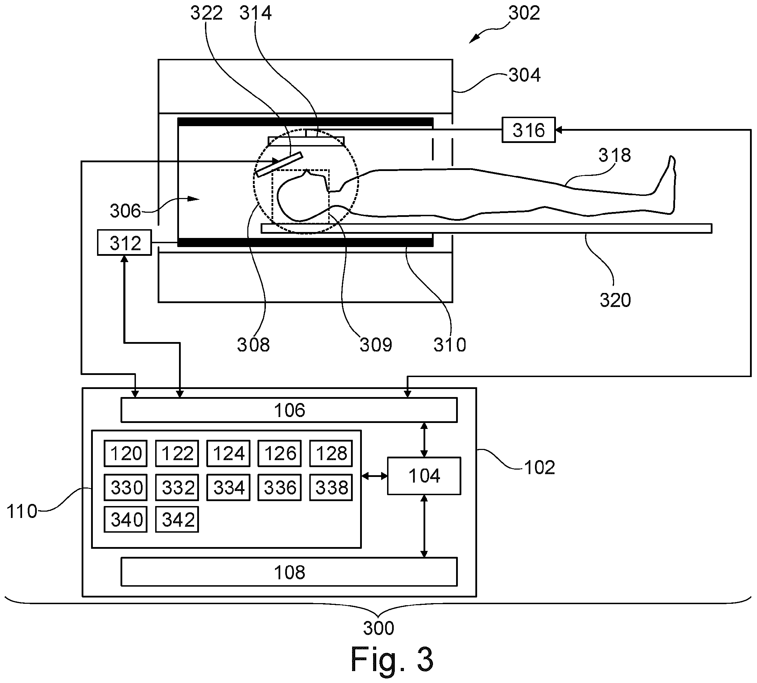

Fig. 3 illustrates a further example of a medical system 300. The medical system 300 depicted in Fig. 3 is similar to the medical system 100 depicted in Fig. 1 except it additionally comprises a magnetic resonance imaging system 302.

The magnetic resonance imaging system 302 comprises a magnet 304. The magnet 304 is a superconducting cylindrical type magnet with a bore 306 through it. It is also possible to use both a split cylindrical magnet and a so-called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject. The arrangement of the two sections area is similar to that of a Helmholtz coil. Open magnets are popular because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A field of view 309 is shown within the imaging zone 308. The k-space data are acquired for the field of view 309. The region of interest could be identical with the field of view 309 or it could be a sub volume of the field of view 309. A subject 318 is shown as being supported by a subject support 320 such that at least a portion of the subject 318 is within the imaging zone 308 and the field of view 309. In this example the field of view 309 is positioned to image the subject's brain.

Within the bore 306 of the magnet there is also a set of magnetic field gradient coils 310 which is used for the acquisition of measured k-space data to spatially encode magnetic spins within the imaging zone 308 of the magnet 304. The magnetic field gradient coils 310 are connected to a magnetic field gradient coil power supply 312. The magnetic field gradient coils 310 are intended to be representative. Typically, magnetic field gradient coils 310 contain three separate sets of coils for spatial encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a radio frequency coil 314 for manipulating the orientations of magnetic spins within the imaging zone 308 and for receiving radio transmissions from spins also within the imaging zone 308. The radio frequency antenna may contain multiple coil elements. The radio frequency antenna may also be referred to as a channel or antenna. The radio frequency coil 314 is connected to a radio frequency transceiver 316. The radio frequency coil 314 and radio frequency transceiver 316 may be replaced by separate transmit and receive coils and a separate transmitter and receiver. It is understood that the radio frequency coil 314 and the radio frequency transceiver 316 are representative. The radio frequency coil 314 is intended to also represent a dedicated transmit antenna and a dedicated receive antenna. Likewise, the transceiver 316 may also represent a separate transmitter and receiver. The radio frequency coil 314 may also have multiple receive/transmit elements and the radio frequency transceiver 316 may have multiple receive/transmit channels. The transceiver 316 and the gradient controller 312 are shown as being connected to the hardware interface 106 of the computer system 102. There is additionally a display 322 which is able to display such things as a rendering controlled by the neural activity signal.

The memory 110 is further shown as containing pulse sequence commands 330. The pulse sequence commands may for example be multi-echo planar imaging pulse sequence commands or, in another example, multi-echo spiral imaging pulse sequence commands. The memory 110 is further shown as containing a calibration group of k-space data that was acquired by controlling the magnetic resonance imaging system 302 with the pulse sequence commands 330. The memory 110 is further shown as containing temporary magnetic resonance images 334 reconstructed from the calibration group of k-space data 332.

These will typically be a magnetic resonance image for each of the echoes. A log-linear fit is then fit for each voxel within these temporary magnetic resonance images 334 to derive the calibration R2* map 122. The memory 110 is further shown as containing the measurement group of k-space data 336 that was acquired using the same pulse sequence commands 330. The memory 110 is further shown as containing short-term magnetic resonance images 338 that were reconstructed from the measurement group of k-space data 336. As with the calibration group of k-space data there is k-space data for each echo and the short-term magnetic resonance images 338 correspond to the k-space data for each echo in the measurement group of k-space data 336. A log-linear fit is then used to construct the current R2* map 124 from the short-term magnetic resonance images 338.

The memory 110 is further shown as containing a classification-matching model 340 that receives as input the three-dimensional fMRI map 126 and in response outputs the neural activity classification 342. As was mentioned above, this may for example be a dictionary-matching algorithm or it may also be a convolutional neural network that was trained for image classification.

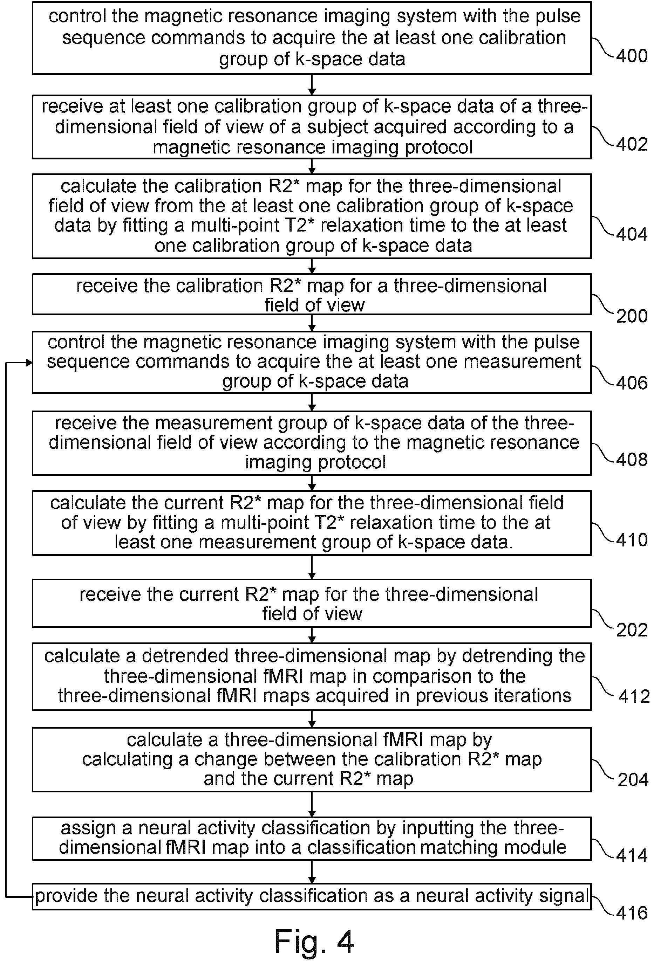

Fig. 4 shows a flowchart which illustrates a method of operating the medical system 300 of Fig. 3. In step 400 the magnetic resonance imaging system 302 is controlled with the pulse sequence commands 330 to acquire the at least one calibration group of k-space data 332. In step 402 the at least one calibration group of k-space data 332 is received. In step 404 the calibration R2* map 122 is calculated from the temporary magnetic resonance images 334. In step 200 the calibration R2* map for the three-dimensional field of view 309 is received. In step 406 the magnetic resonance imaging system 302 is controlled with the same pulse sequence commands 330 to acquire the at least one measurement group of k-space data 336. In step 408 the measurement group of k-space data 336 is received. In step 410 the current R2* map 124 is calculated for the three-dimensional field of view using the at least one measurement group of k-space data 336. In step 202 the current R2* map 124 is received.

Step 412 is optional. In this step a detrended three-dimensional map is calculated by detrending the three-dimensional fMRI map in comparison to the three-dimensional fMRI maps acquired in previous iterations. In step 204 the three-dimensional functional magnetic resonance image map 126 is calculated by determining a change or difference between the calibration R2* map 122 and the current R2* map 124. In step 414 a neural activity classification 342 is assigned by inputting the three-dimensional map into a classification-matching module 340. In step 416 the neural activity classification 342 is provided as a neural activity signal. The neural activity signal may for example be used to control the display 322. This may enable the operation of the medical system 300 as a biofeedback system for the subject 318.

As was mentioned above, there may be drawbacks to using the signal intensity for constructing fMRI images. Variations in the signal intensity can, for example, caused by motion, cardiac and respiratory effects, and scanner instabilities.

For changes in neural activity, T2* changes because of changes in oxy-dexoyHB. The susceptibility changes, which are a better measure for the true functional activity, can be quantified by determining the transverse relaxation, the so-called T2*. Mapping changes in T2*star may therefore be a better measure for functional activation than "traditional" BOLD techniques. A multi-echo fMRI sequence is used that measures the signal at multiple echo times, typically 3 echoes are acquired with echo-times, for example, around 10, 30 and 50 ms, respectively. The signal decay for a multi echo acquisition is described by:

$$S(TE) = S_0 \, e^{\frac{-TE}{T_2^*}}, \quad (1)$$

where TE is the echo time and So is the signal at TE = 0. So is the signal at TE=0. Therefore So does not contain functional information. Only signal intensity which can be affected by the confounders

The changes in T2* are related to susceptibility variations resulting from functional activity. The So reflects the non-BOLD variations of the signal intensity which can be caused by motion, cardiac and respiratory effects. Because of the difference in the nature of the two parameters, the T2* is believed to be a better representation of the functional activity compared to the BOLD effect.

Examples may provide for a means to determine variations of functional brain networks in real-time is presented which is based on the fluctuation of the T2* relaxation rate.

A major problem in fMRI is that the BOLD signal changes are small and that there are also non-BOLD related effects that cause signal changes. The most commonly sources for these confounders are, head motion, cardiac and respiratory effect, also, scanner related artefacts cause signal changes. This can be overcome by analyzing the T2* changes derived from multi-echo fMRI.

A recent development is real-time fMRI. In this application the functional changes are determined for each time point individually. These changes can then be used either for monitoring and control, or as a feedback signal. The aim of this neurofeedback is that the subject can be trained to correct aberrant brain activity. For successful real-time applications it is essential that the true functional variations are measured with as little as possible contamination by the confounders. The use of T2* changes, as used in examples, may possibly result in improved real-time functional brain data.

Some examples may use T2* to measure complete functional network responses and thus, for example, giving feedback on the true networks variations rather than just using changes in selected connectivity hubs.

The neurofeedback for selected connectivity's may result in changes in the resting state networks. In examples a resting state run was done after the neurofeedback scans. The resting-state data were analyzed after the scan was completed and showed changes in the brain networks. Examples may provide for the analysis of whole neural activity networks in real-time, potentially providing improved feedback and reduction of total scan time. This may lead to an improved understanding of the neural resting state processes.

In some examples, the fMRI images are acquired using a multi-echo fMRI sequence. ME-EPI is known from literature and So and T2* have already been used in the analysis of complete data sets. Here, we propose an analysis for each individual dynamic in real-time. From the multi echo data both the So and the R2* maps are calculated for each dynamic. In the next steps only the R2* maps are used. For resting state analysis, the k-space data may be acquired during a moving window of one minute are averaged. For the next acquired fMRI volume, the voxel-wise percentage-signal-change of the R2* maps is calculated with respect to the moving window average. Functional networks for individual time points are often also referred to as 'co-activation patterns.

In real-time fMRI it is common to determine the signal change compared to an average. However, these signal changes are based on single-echo fMRI data and therefore, can also contain non-BOLD related signal changes.

Examples may use multi-echo fMRI data and used the fitted T2* to calculate the functional networks response per individual dynamic reducing the contamination from confounders, such as cardiac and respiratory effects, motion, and scanner instabilities.

The functional neural activation networks may be determined for each time volume. The full functional network data can be used for further purposes, such as neurofeedback or real-time control of the data acquisition.

An example of an fMRI map acquisition is detailed below. In this example, k-space data is acquired using a multi-echo single shot EPI sequence. Typically, 3 echoes are recorded with echo-time approx. 10, 30 and 50 ms, respectively. Repetition time (TR) and spatial resolution can be varying according to the desired setting. An example of the settings are: TE = 11 , 31.5, 52ms, TR= 1350 ms, voxel size 2.7 mm isotropic. For scan-time reduction both SENSE and MB-SENSE are used, factors 2.5 and 3, respectively.

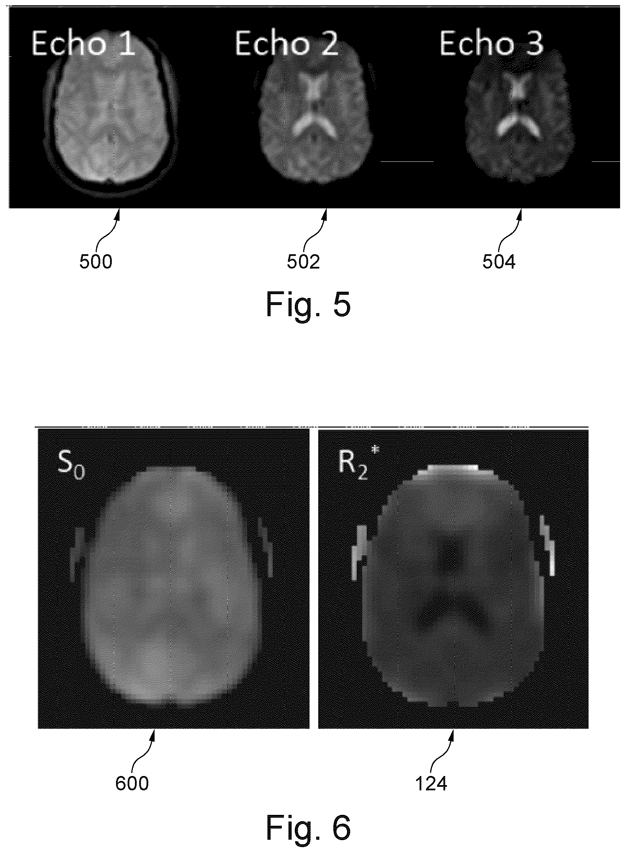

This fMRI scan results in 3 volumes for each TR. Fig. 5 shows three examples of magnetic resonance images constructed from the k-space data recorded for three separate echoes. There is a short-term magnetic resonance image reconstructed from the first echo 500, a short-term magnetic resonance image reconstructed from the second echo 502 and a short-term magnetic resonance image reconstructed from the third echo 504.

Fig. 6 shows an So and R2* map constructed from the images shown in Fig. 5. These images, 500, 502, 504 are then fit according to equation 1 above to calculate an S0 map and R2* map 124. In functional magnetic resonance imaging typically the S0 map 600 is used. The R2* map 124 may be used to improve the quality of the image for functional magnetic resonance images but the map 600 is still used. In examples, the R2* map 124 is used as the functional magnetic resonance image.

An example of the data processing is given below. Note that data processing can also be performed off-line after the acquisition is finished or be performed in real time.

Example of a real-time embodiment (in pseudocode):

```
Receive multi-echo data from scanner
e1_d#.nii
e2_d#.nii
e3_d#.nii
Realignment (step 1)
Initialise on e1_d1 (SPM)
Ref: e1_d1.nii
Template re1_d1.nii
Fit R2* decay
Smooth echo data
Log linear fit (assume no motion between the acquisition of the echoes)
Output R2star_d#.nii
Realignment (step 2)
Realign e1_d# to ref (SPM)
Apply realignment to R2star.nii
Output rR2star.nii
```

The R2* data are used for the analysis of the resting-state functional networks. Example of the current implementation:

```
The first 40 R2* maps are collected
In order to get the functional networks:

    Add the newly acquired rR2star map
    Remove first map (moving window)
    Detrend all (linear)
    Mean of first 39 maps (detrend)
    PSC of map 40 w.r.t the mean (detrend)
```

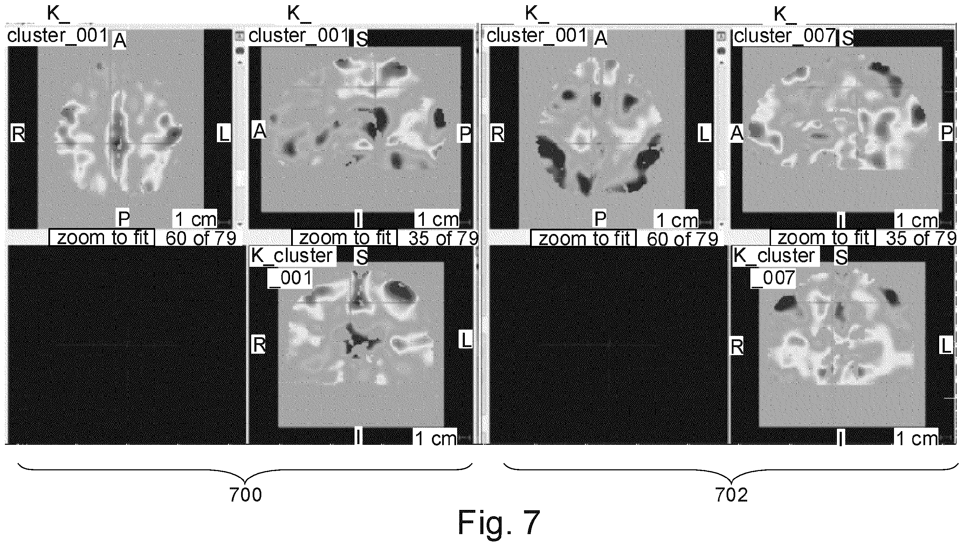

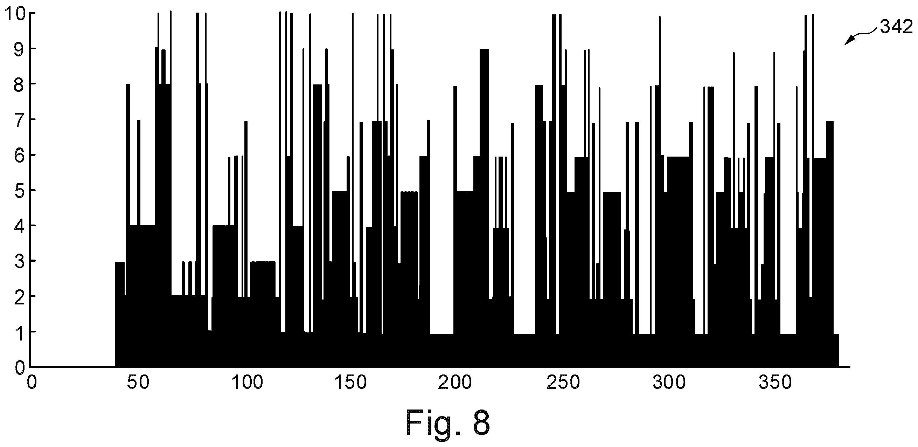

Fig. 7 shows two examples of additional functional magnetic resonance images 700 and 702. reconstructed using this technique. When a large number of functional magnetic resonance images, such as 700 and 702, have been measured for a subject they may be grouped together using cluster analysis. The various images may then be assigned to different groups using this cluster analysis. In Fig. 8 the various functional magnetic resonance images have been divided into ten classifications. The y-scale labeled 1 through 10 are the 10 classifications and the x-axis indicates individual measurements. Division into different classifications is an example of a neural activity classification 342. Fig. 700 corresponds to classification 1 and Fig. 702 corresponds to classification 7 in Fig. 8.

In this implementation the average is over a period of ~52 seconds. The date set of the next example contains 380 time points. Therefore, the analysis results in 340 networks or co-activation patterns. For quality analysis purposes the number of images was reduced, as mentioned above, using k-means clustering. In this example cluster size was 10. Note the clustering in this example was not applied in real-time but can be used in off-line processing.

The clustering is a powerful addition to the off-line processing since it can be used to order the images and get valuable information on how to appear in time.

In a further example, a fixed resting-state period at the beginning of the fMRI scan can be used as reference for the analysis of the subsequent time points.

In a further example, resting state runs and real-time analysis are interleaved with neurofeedback sessions.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A 'computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

'Computer memory' or 'memory' is an example of a computer-readable storage medium. Computer memory is any memory which is directly accessible to a computational system. 'Computer storage' or 'storage' is a further example of a computer-readable storage medium. Computer storage is any non-volatile computer-readable storage medium. In some embodiments computer storage may also be computer memory or vice versa.

A 'computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A 'user interface' as used herein is an interface which allows a user or operator to interact with a computer or computer system. A 'user interface' may also be referred to as a 'human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A 'hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or 'display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data is defined herein as being the recorded measurements of radio frequency signals emitted by atomic spins using the antenna of a Magnetic resonance apparatus during a magnetic resonance imaging scan. Magnetic resonance data is an example of tomographic medical image data.

A Magnetic Resonance Imaging (MRI) image or MR image is defined herein as being the reconstructed two- or three-dimensional visualization of anatomic data contained within the k-space data. This visualization can be performed using a computer.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measured cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

REFERENCE SIGNS LIST

100    medical system
102    computer
104    computational system
106    optional hardware interface
108    optional user interface
110    memory
120    machine executable instructions
122    calibration R2* map
124    current R2* map
126    three-dimensional fMRI map
200    receive a calibration R2* map for a three-dimensional field of view

202    receive a current R2* map for the three-dimensional field of view
204    calculate a three-dimensional fMRI map by calculating a change between the calibration R2* map and the current R2* map
300    medical system
302    magnetic resonance imaging system
304    magnet
306    bore of magnet
308    imaging zone
309    field of view
310    magnetic field gradient coils
312    magnetic field gradient coil power supply
314    radio frequency coil
316    transceiver
318    subject
320    subject support
322    display
330    pulse sequence commands
332    calibration group of k-space data
334    temporary magnetic resonance images
336    measurement group of k-space data
338    short term magnetic resonance images
340    classification matching module
342    neural activity classification
400    control the magnetic resonance imaging system with the pulse sequence commands to acquire the at least one calibration group of k-space data
402    receive at least one calibration group of k-space data of the three-dimensional field of view of the subject acquired according to a magnetic resonance imaging protocol, wherein the magnetic resonance imaging protocol is a multi-point T2* measurement pulse sequence
404    calculate the calibration R2* map for the three-dimensional field of view from the at least one calibration group of k-space data by fitting a multi-point T2* relaxation time to the at least one calibration group of k-space data
406    control the magnetic resonance imaging system with the pulse sequence commands to acquire the at least one measurement group of k-space data
408    receive a measurement group of k-space data of the three-dimensional field of view according to the magnetic resonance imaging protocol
410    calculate the current R2* map for the three-dimensional field of view by fitting the multi-point T2* relaxation time to the measurement group of k-space data
412    calculate a detrended three-dimensional fMRI map by detrending the three-dimensional fMRI map in comparison to the tree-dimensional fMRI maps acquired in previous iterations
414    assign a neural activity classification by inputting the detrended three-dimensional map into a classification matching module; and
416    provide the neural activity classification as a neural activity signal
500 short term magnetic resonance image for first echo
502 short term magnetic resonance image for second echo
504 short term magnetic resonance image for third echo
600 So map
700 three-dimensional fMRI map
702 three-dimensional fMRI map

**Claims**

1. A medical system (100, 300) comprising:

   - a memory (110) storing machine executable instructions (120),
   - a computational system (104), wherein execution of the machine executable instruction causes the computational system to receive (200) a calibration R2* map (122) for a three-dimensional field of view (309), wherein the three-dimensional field of view is descriptive of at least a portion of a brain of a subject (318);

   wherein execution of the machine executable instructions further causes the computational system to perform the following at least once:

   - receive (202) a current R2* map (124) for the three-dimensional field of view; and
   - calculate (204) a three-dimensional fMRI map (126) by calculating a change between the calibration R2* map and the current R2* map.

2. The medical system of claim 1, wherein execution of the machine executable instructions further causes the computational system to:

   - receive (402) at least one calibration group of k-space data (332) of the three-dimensional field of view of the subject acquired according to a magnetic resonance imaging protocol, wherein the magnetic resonance imaging protocol is a multi-point T2* measurement pulse sequence;
   - calculate (404) the calibration R2* map for the three-dimensional field of view from the at least one calibration group of k-space data by fitting a multi-point T2* relaxation time to the at least one calibration group of k-space data;

   wherein execution of the machine executable instructions further causes the computational system to perform the following at least once:

   - receive (408) a measurement group of k-space data (336) of the three-dimensional field of view according to the magnetic resonance imaging protocol; and
   - calculate (410) the current R2* map for the three-dimensional field of view by fitting the multi-point T2* relaxation time to the measurement group of k-space data.

3. The medical system of claim 2, wherein the medical system further comprises a magnetic resonance imaging system (302), wherein the memory stores pulse sequence commands (330) configured to control the magnetic resonance imaging system to acquire k-space data according to the magnetic resonance imaging protocol, wherein execution of the machine executable instructions further causes the computational system to:

   - control (400) the magnetic resonance imaging system with the pulse sequence commands to acquire the at least one calibration group of k-space data; and
   - control (406) the magnetic resonance imaging system with the pulse sequence commands to acquire the at least one measurement group of k-space data.

4. The medical system of claim 3, wherein the acquisition of the at least one measurement group of k-space data is acquired repeatedly, wherein the calculation of a three-dimensional fMRI map is performed when the at least one measurement group of k-space data is received.

5. The medical system of any one of the preceding claims, wherein execution of the machine executable instructions further causes the computational system to:

   - reconstruct a temporary magnetic resonance image for each member of the calibration group of k-space data;
   - align the temporary magnetic resonance image for each member of the of the calibration group of k-space data;
   - smooth the temporary magnetic resonance image for each member of the calibration group of k-space data, wherein the calibration R2* map is calculated by performing a log-linear fit to the smoothed temporary magnetic resonance image for each member of the calibration group of k-space data.

6. The medical system of any one of the preceding claims, wherein execution of the machine executable instructions further causes the computational system to:

   - reconstruct a short-term magnetic resonance image for each member of the measurement group of k-space data;

- align the short-term magnetic resonance image for each member of the of the measurement group of k-space data;

- smooth the short-term magnetic resonance image for each member of the measurement group of k-space data, wherein the current R2* map is calculated by performing a log-linear fit to the smoothed short-term magnetic resonance image for each member of the measurement group of k-space data.

7. The medical system of any one of the preceding claims, wherein execution of the machine executable instructions further causes the computational system to align the current R2* map with the calibration R2* map before calculating the three-dimensional fMRI map.

8. The medical system of any one of the preceding claims, wherein execution of the machine executable instructions further causes the computational system to:

- assign (414) a neural activity classification (342) by inputting the detrended three-dimensional map into a classification matching module (340); and
- provide (416) the neural activity classification as a neural activity signal.

9. The medical system of claim 8, wherein the classification matching module is implemented as any one of the following: a neural network configured to output the neural activity classification, by comparing the three-dimensional fMRI map to a library, and by using cluster analysis.

10. The medical system of any one of the preceding claims, wherein execution of the machine executable instructions further causes the computational system to provide the neural activity signal in real time.

11. The medical system of claim 10, wherein the medical system further comprises a user interface device (322) configured to provide sensory stimulation to the subject, wherein execution of the machine executable instructions further causes the computational system to control the user interface device with the neural activity signal to provide a biofeedback system.

12. The medical system of any one of the preceding claims, wherein the pulse sequence is a multi-echo echo planar imaging pulse sequence or a multi-echo spiral imaging pulse sequence.

13. The medical system of any one of the preceding claims, wherein the pulse sequence commands are configured to acquire the k-space data at: a first echo between 6 ms and and 14 ms, a second echo between 15 ms and 39 ms, and a third echo between 40 ms and 65 ms.

14. A method of operating a medical system (100, 300), wherein the method comprises receiving (200) a calibration R2* map (122) for a three-dimensional field of view (309), wherein the three-dimensional field of view is descriptive of at least a portion of a brain of a subject (318); wherein the method further comprises to performing the following at least once:

- receiving (202) a current R2* map for the three-dimensional field of view; and
- calculating (204) a three-dimensional fMRI map by calculating a change between the calibration R2* map and the current R2* map.

15. A computer program comprising machine executable instructions for execution by a computational system (104), wherein execution of the machine executable instruction causes the computational system to receive (200) a calibration R2* map (122) for a three-dimensional field of view (309), wherein the three-dimensional field of view is descriptive of at least a portion of a brain of a subject (318); wherein execution of the machine executable instructions further causes the computational system to perform the following at least once:

- receive (202) a current R2* map (124) for the three-dimensional field of view; and
- calculate (204) a three-dimensional fMRI map (126) by calculating a change between the calibration R2* map and the current R2* map.

Fig. 1

200

receive a calibration R2* map for a three-dimensional
field of view

202

receive a current R2* map for the three-dimensional
field of view

204

calculate a three-dimensional fMRI map by calculating a
change between the calibration R2* map and the
current R2* map

Fig. 2

Fig. 3

control the magnetic resonance imaging system with the pulse sequence commands to acquire the at least one calibration group of k-space data ⟩—400

receive at least one calibration group of k-space data of a three-dimensional field of view of a subject acquired according to a magnetic resonance imaging protocol ⟩—402

calculate the calibration R2* map for the three-dimensional field of view from the at least one calibration group of k-space data by fitting a multi-point T2* relaxation time to the at least one calibration group of k-space data ⟩—404

receive the calibration R2* map for a three-dimensional field of view ⟩—200

control the magnetic resonance imaging system with the pulse sequence commands to acquire the at least one measurement group of k-space data ⟩—406

receive the measurement group of k-space data of the three-dimensional field of view according to the magnetic resonance imaging protocol ⟩—408

calculate the current R2* map for the three-dimensional field of view by fitting a multi-point T2* relaxation time to the at least one measurement group of k-space data. ⟩—410

receive the current R2* map for the three-dimensional field of view ⟩—202

calculate a detrended three-dimensional map by detrending the three-dimensional fMRI map in comparison to the three-dimensional fMRI maps acquired in previous iterations ⟩—412

calculate a three-dimensional fMRI map by calculating a change between the calibration R2* map and the current R2* map ⟩—204

assign a neural activity classification by inputting the three-dimensional fMRI map into a classification matching module ⟩—414

provide the neural activity classification as a neural activity signal ⟩—416

## Fig. 4

Fig. 5

Fig. 6

Fig. 7

Fig. 8

Europäisches Patentamt
European Patent Office
Office européen des brevets

## EUROPEAN SEARCH REPORT

Application Number

EP 23 17 6675

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/034984 A1 (LAMERICHS RUDOLF MATHIAS JOHANNES NICOLAAS [NL] ET AL) 3 February 2022 (2022-02-03) * paragraphs [0012] – [0014], [0020], [0021], [0040], [0052] – [0059], [0064] – [0068], [0074] – [0085]; claim 1; figures 1, 2, 4, 5B-5C * | 1-15 | INV. G01R33/50 G01R33/48 |
| X | EP 4 152 032 A1 (KONINKLIJKE PHILIPS NV [NL]) 22 March 2023 (2023-03-22) * paragraphs [0008], [0009], [0030], [0031], [0072], [0085] – [0090]; figures 2,8,9 * | 1-10, 12-15 | |
| A | US 2016/054409 A1 (WAGER TOR [US] ET AL) 25 February 2016 (2016-02-25) * paragraph [0062]; figure 5 * | 8,9 | |

TECHNICAL FIELDS SEARCHED (IPC)

G01R

The present search report has been drawn up for all claims

| Place of search | Date of completion of the search | Examiner |
|---|---|---|
| Munich | 16 November 2023 | Faber-Jurk, Sonja |

## ANNEX TO THE EUROPEAN SEARCH REPORT
## ON EUROPEAN PATENT APPLICATION NO.

EP 23 17 6675

This annex lists the patent family members relating to the patent documents cited in the above-mentioned European search report.
The members are as contained in the European Patent Office EDP file on
The European Patent Office is in no way liable for these particulars which are merely given for the purpose of information.

16-11-2023

| Patent document cited in search report | | Publication date | Patent family member(s) | | Publication date |
|---|---|---|---|---|---|
| US 2022034984 | A1 | 03-02-2022 | CN | 113167849 A | 23-07-2021 |
| | | | EP | 3660530 A1 | 03-06-2020 |
| | | | EP | 3887842 A1 | 06-10-2021 |
| | | | JP | 7183419 B2 | 05-12-2022 |
| | | | JP | 2022501157 A | 06-01-2022 |
| | | | US | 2022034984 A1 | 03-02-2022 |
| | | | WO | 2020109095 A1 | 04-06-2020 |
| EP 4152032 | A1 | 22-03-2023 | CN | 116583221 A | 11-08-2023 |
| | | | EP | 4152032 A1 | 22-03-2023 |
| | | | EP | 4237868 A1 | 06-09-2023 |
| | | | WO | 2023041339 A1 | 23-03-2023 |
| US 2016054409 | A1 | 25-02-2016 | US | 2016054409 A1 | 25-02-2016 |
| | | | WO | 2014169060 A1 | 16-10-2014 |

EPO FORM P0459

For more details about this annex : see Official Journal of the European Patent Office, No. 12/82